# EUROPEAN PATENT APPLICATION

(11) **EP 0 660 408 A1**
(43) Date of publication of application: **28.06.1995**
(21) Application number: 94309036.5
(22) Date of filing: 05.12.1994
(51) Int. Cl.: H01L 23/525

(54) **A method of manufacturing antifuse devices**

(30) Priority: 16.12.1993 US 168601
(71) Applicant: UNITED TECHNOLOGIES CORPORATION, Hartford, CT 06101 (US)
(72) Inventor: Hafer, Craig C., Colorado Springs, Colorado 80919 (US)
(74) Representative: Gilding, Martin John

(57) **Abstract**

The present invention teaches a method of manufacturing antifuse devices. The method comprises several steps the first of which involves forming a first conductive layer (14) superjacent a semiconductor substrate. Second, a patterned antifuse layer (15) is formed superjacent the patterned first conductive layer. Third, the first conductive layer (14) is patterned. Fourth, a patterned first dielectric layer (22) having a first and second via is formed superjacent the resultant structure of the previous step. Fifth, a second conductive layer (42,44) is formed superjacent the resultant structure of the previous step, thereby providing electrical contacts between the second conductive layer and the patterned antifuse layer and between the second conductive layer and the first conductive layer.

## Description

### Technical Field

This invention relates to the field of semiconductor devices, and more particularly antifuses.

### Background Art

In the semiconductor industry, programmable memory devices are known. These devices, such as one time programmable read only memories ("OTPROMs"), store individual binary bits of information in memory cells. Once programmed, these memories are essentially limited to being "read only" devices, and thus cannot be reprogrammed. Further, data stored within the memory is non-volatile, which enables its preservation when power is removed.

OTPROMs comprise a plurality of word lines, and a plurality of parallel bit lines. The bit lines are perpendicular to the word lines and the general area of each intersection of a word line and a bit line or pair of bit lines, along with any associated circuitry, constitutes a single memory cell. A plurality of cells structured as an array, thus, form a device.

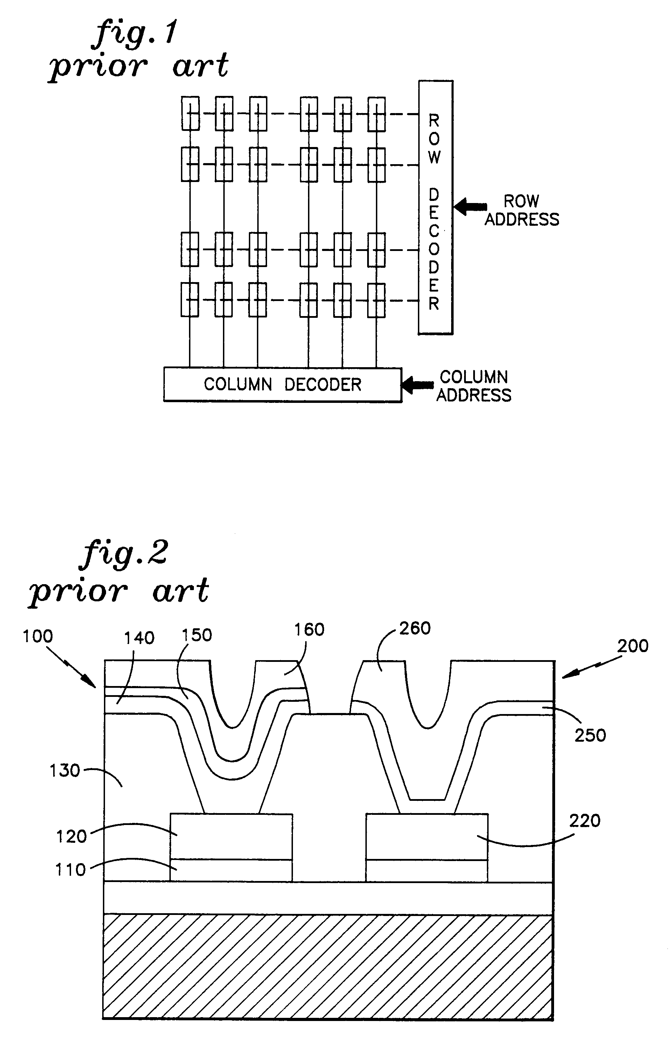

Referring to Figure 1, an array of memory cells is illustrated. A row and column decoder is incorporated for providing selective access to each cell of the programmed memory. Further, each cell comprises a means for selectively coupling a semiconductor device to a predetermined voltage, thereby enabling the device to be programmed.

Normally, the presence or absence of a conducting semiconductor device, diode or transistor, connecting the bit line to a predetermined voltage determines the binary "1" or "0" state of the memory cell. The absence of a conducting semiconductor can result from (1) the absence of a complete transistor or diode, or (2) the presence of a high resistance in series with the semiconductor.

Fundamentally, the absence of a conducting semiconductor can be achieved by several means known in the art. One known approach is usage of fuse-type coupling. By linking semiconductor through a fuse, its absence is only achieved when a sufficient voltage is applied so as to disintegrate the fusible link.

Another methodology known in the art has been to employ an antifuse link having a thin dielectric layer. Each conducting semiconductor employing this technique is electrically isolated from the memory prior to programming. By applying appropriate voltages to the antifuse, the dielectric layer can be disabled, thereby coupling the conducting semiconductor to the memory.

The manufacture of antifuse links, thus, is of critical importance in making these programmable devices. Referring to Figure 2, a semiconductor is shown having a known antifuse link structure 100 and a non-antifuse contact 200. Traditionally, antifuse links have been fabricated by depositing a layer of antifuse material 140 through a via formed within a patterned dielectric layer 130.

Prior to forming layer 140, however, a patterned first barrier layer, 120 and 220, typically comprising TiW, is formed such that the upper surface of the first portion of first barrier layer, 120, is in direct contact with the bottom surface of antifuse layer 140. Patterned first barrier layer, 120 and 220, in turn is in direct contact with a first conductive layer 110.

Similarly, a patterned second barrier layer, 150 and 250, typically comprising TiW, is formed superjacent both antifuse cell 100 and non-antifuse contact 200, prior to being patterned to simplify manufacturing. The first portion of patterned second barrier layer, 150, comprise a second conductive layer, 160, formed superjacent. Further, the second portion of patterned second barrier layer, 250, is formed superjacent the second portion of the first patterned barrier layer 220, as non-antifuse contact 200 does not have an antifuse layer.

As a result of this known antifuse configuration, the layer of antifuse material 140 takes on a "V" shape. Further, second barrier layer 150 comprises a shape conformal with antifuse layer 140. Thus, second barrier layer 150 also has a "V" shape.

Several problems exist with this known antifuse link structure. Firstly, localized thinning exists in he layer of antifuse material because of its "V" shape. This is further supported by the fact that antifuse material typically employed in antifuse structures is amorphous silicon. Amorphous silicon inherently does not conform to non-planar surfaces, and thus will be formed non-uniformly within the antifuse cell. This failing has a direct impact on the programmability of the overall device, as each cell comprises a variable programmable voltage. Moreover, the overall device comprises additional resistivity by having a first and second barrier layer formed within the non-antifuse contact. Further, second conductive layer 160 cannot sufficiently wet in this configuration. This shortcoming results in the thinning of second conductive layer 160 through the via in the patterned dielectric layer 130. Given these shortcomings, a new antifuse cell and a method of making this device is required.

### Disclosure of the Invention

The primary advantage of the present invention is to provide an antifuse device and a method of making this device having greater reliability.

Another advantage of the present invention is to provide an antifuse device and a method of making this device having more uniform programmable voltages and unprogrammed resistances.

A further advantage of the present invention is to provide an antifuse device and a method of making this device having a more uniform layer of antifuse material.

Still another advantage of the present invention is to provide an antifuse device and a method of making this device having a sufficient thickness within its top conductive layer.

Still a further advantage of the present invention is to provide an antifuse device and a method of making this device having a non-antifuse via comprising sufficiently reduced resistivity.

In order to achieve the advantages of the present invention, a method of fabricating a semiconductor wafer is disclosed. In the first step of the method, a first conductive layer is formed superjacent a semiconductor substrate. Second, a patterned antifuse layer having a structural configuration is formed superjacent the first conductive layer. Third, the first conductive layer is patterned. Fourth, a patterned first dielectric layer is formed superjacent the patterned antifuse layer and the first conductive layer. The patterned first dielectric layer comprises a first and second via, such that a portion of the patterned antifuse layer is exposed through the second via, and a portion of the first conductive layer is exposed through the first via, thereby forming a resultant structure. Fifth, a second conductive layer is formed superjacent the resultant structure, thereby providing electrical contacts between the second conductive layer and the patterned antifuse layer and between the second conductive layer and the first conductive layer.

Other aspects and advantages will become apparent to those skilled in the art from the following detailed description read in conjunction with the appended claims and the drawings attached hereto.

### Brief Description of the Drawings

The present invention will be better understood from reading the following description of non-limited embodiments, with reference to the attached drawings, wherein below:
Figure 1 is a schematic view of an array of memory cells;
Figure 2 illustrates a semiconductor having a known antifuse structure;
Figure 3 illustrates a semiconductor structure formed according to a first step of the present invention;
Figure 4 illustrates a semiconductor structure formed according to a second step of the present invention;
Figure 5 illustrates a semiconductor structure formed according to the third step of the present invention;
Figure 6 illustrates a semiconductor structure formed according to the fourth step of the present invention;
Figure 7 illustrates a semiconductor structure formed according to the fifth step of the present invention;
Figure 8 illustrates a semiconductor structure formed according to the sixth step of the present invention;
Figure 9 illustrates a semiconductor structure formed according to the seventh step of the present invention; and
Figure 10 illustrates a topographical perspective of the completed semiconductor structure of the present invention.

It should be emphasized that the drawings of the instant application are not to scale but are merely schematic representations and are not intended to portray the specific parameters or the structural details of the invention, which can be determined by one of skill in the art by examination of the information herein.

### Detailed Description of the Invention

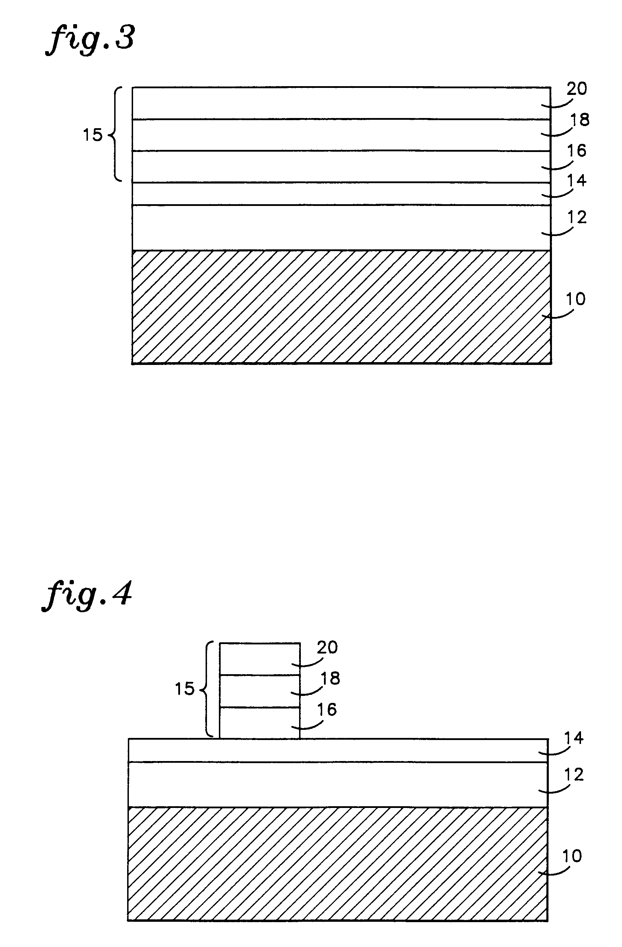

Referring to Figure 3, a semiconductor structure formed according to a first step of the present invention is shown. Here, a semiconductor substrate 10 is depicted. Substrate 10 can comprises a variety of materials including silicon and polycrystalline silicon. Formed on substrate 10 are various transistors, such as complementary metal oxide semiconductors ("CMOS"), not shown for the purposes of illustrating the present invention.

Formed superjacent substrate 10 is a first dielectric layer 12. Dielectric layer 12 preferably comprises a layer of reflow glass for the purposes of insulating portions of the substrate 10 from the structure to be formed superjacent. As such, dielectric layer 12 comprises a glass silicate, such as borophosphosilicate glass ("BPSG"), phosphosilicate glass ("PSG") or silicon dioxide, and has a thickness substantially in the range of 7000Å to 9000Å. The formation of first dielectric layer 12 can be achieved through a variety of methods, such as low pressure chemical vapor deposition ("LPCVD"), atmospheric pressure chemical vapor deposition ("APCVD"), and plasma enhanced pressure chemical vapor deposition ("PECVD"). In one embodiment of the present invention, first dielectric layer is also planarized.

Superjacent first dielectric layer 12 is formed a first conductive layer 14. Conductive layer 14 comprises a metallization layer and a preferable thickness substantially in the range of 5000Å to 7000Å. In the preferred embodiment of the present invention, conductive layer 14 comprises an aluminum (98.5% concentration by weight), copper (0.5% concentration by weight) and silicon (1% concentration by weight) compound. The formation of first conductive layer 14 can be achieved through various methods known, including sputtered deposition techniques and evaporation deposition techniques.

To fabricate an antifuse device, an antifuse layer or cell 15 is positioned and formed superjacent first conductive layer 14. Antifuse cell 15 essentially comprises three layers. Superjacent first conductive layer 14 is a first barrier layer 16 comprising TiW, which preferably comprises a 10% Titanium and 90% Tungsten composition. However, TiN can also be used in the alternative. Further, V, Ni, Cr, Co, Ag and Al have been shown effective in forming electrodes and thus may also be employed. First barrier layer 16 comprises a thickness of substantially within the range of 1200Å to 2000Å, though 1750Å is preferred, and is deposited superjacent first conductive layer 14 by means of sputtered or evaporation deposition techniques.

Further, a second layer of dielectric material 18 is formed superjacent the first barrier layer 16. Layer 18 can be formed by several techniques, including plasma enhanced chemical vapor deposition ("PECVD") and LPCVD. Second dielectric layer 18 comprises a thickness substantially in the range of 800-1600Å, though 1100Å is preferred. Unlike the first dielectric layer, second dielectric or antifuse layer 18 preferably comprises undoped amorphous silicon. Undoped amorphous silicon is preferred because it is substantially reliable, it can be formed with a sufficient thickness at a final alloy temperature of 415°C, and has a substantially low capacitance. Thus, undoped amorphous silicon is preferred in fabricating antifuse layers because of its dielectric properties' propensity to disintegrate, by applying a substantially low voltage (7.5-12 volts). This disintegration is explained by the fact that as the programming voltage applied reaches the breakdown level of the dielectric layer, leakage current begins to pass through a localized weak spot in the dielectric layer, which results in heating the weak spot. As the weak spot is further heated, more leakage current passes and a thermal runaway condition develops until the dielectric layer melts down or disintegrates.

It should be obvious to one of ordinary skill in the art, however, that antifuse layer 18 can also comprise polysilicon, silicon doped with phosphorus, boron or a combination thereof, and an oxide-nitrideoxide dielectric sandwich. By controlling this step of disintegration, the antifuse can be employed in programming memory devices.

The antifuse cell is completed by forming a second barrier layer 20 superjacent second dielectric layer 18. As with first barrier layer 16, second barrier layer 20 comprises TiW, which preferably comprises a 10% titanium and 90% tungsten composition. However, second barrier layer can also comprise TiN. Further, V, Ni, Cr, Co, Ag and Al have been shown effective in forming electrodes and thus may also be employed. Second barrier layer 18 comprises a thickness of substantially within the range of 1200Å to 2000Å, though 1750Å is preferred. Further, second barrier layer 20 is deposited superjacent first conductive layer 14 also by means of sputtering or evaporative deposition techniques.

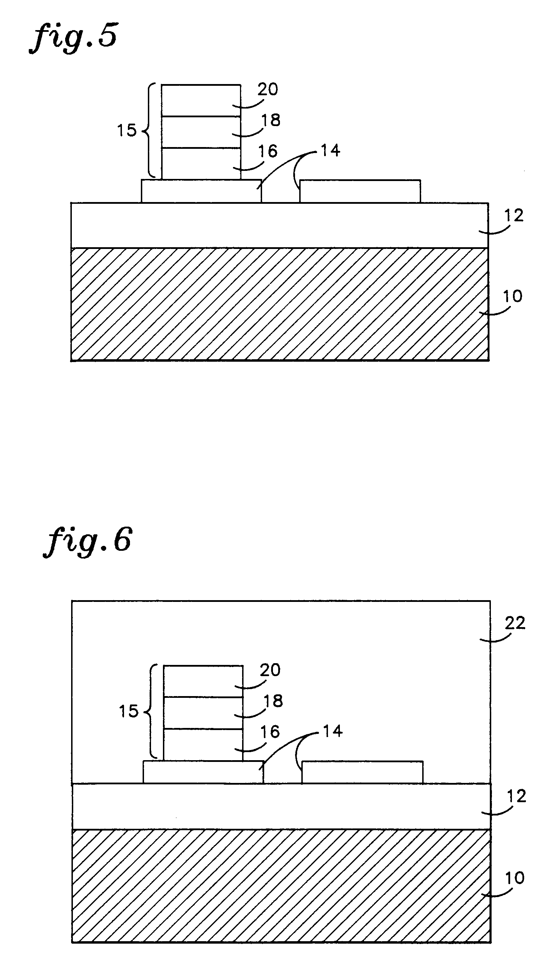

Referring to Figure 4, a semiconductor structure formed according to a second step of the present invention is depicted. Upon completing its formation superjacent first conductive layer 14, only antifuse cell 15 is patterned. By this arrangement, the cell has critical dimensions such that the via edge is away from the edge of the antifuse cell 15. As such, these dimensions are on the order of approximately 1.2 to 1.5 µm. It should be noted that the result of this patterning has no substantial impact on the remaining semiconductor structure other than the patterning of the antifuse cell 15. This is supported by the fact the first conductive layer 14 has good etch stop properties.

The step of patterning the antifuse cell 15 can be achieved by several techniques, including a three step process. By this process, a layer of photoresist is patterned over the desired areas that are to remain. Subsequently, an etching step is employed to remove those regions according to predetermined photoresist pattern. In the preferred embodiment of the present invention, the etching step of the antifuse cell employs at least one of CF₄, O₂, and Cl₂ etch chemistries which stops on first conductive layer 14 because of the particular chemical properties of the preferred aluminum compound of 98.5% aluminum, 1% silicon and 0.5% copper. Thereafter, the photoresist is removed.

Referring to Figure 5, a semiconductor structure formed according to a third step of the present invention is illustrated. Here, the first conductive layer 14 is patterned while maintaining the structural integrity of the antifuse cell. The result of this patterning, however, has no substantial impact on the remaining semiconductor structure of Figure 4 other than the patterning of the first conductive layer 14.

As described herein, the step of patterning incorporates several process steps. In one embodiment, a layer of photoresist is patterned over the antifuse cell 15, as well as those areas on the first conductive layer 14 that are to remain. Subsequently, an etching step is employed, preferably using plasma dry etch techniques along with Cl₂, BCl₃, or CH₄ chemistries, to remove those regions bare, without photoresist, while leaving intact those areas covered with photoresist. Once etched, the photoresist is removed.

Referring to Figure 6, a semiconductor structure formed according to a fourth step of the present invention is illustrated. Once both the antifuse cell 15 and first conductive layer 14 have been patterned, a third dielectric layer 22, also referred to as an intermetal oxide deposition layer, is formed superjacent the resultant patterned structure. As described hereinabove, third dielectric layer 22 is deposited superjacent the patterned structure of Figure 5 utilizing either PECVD, LPCVD or APCVD techniques. Third dielectric layer 22 is then planarized.

Third dielectric layer 22 comprises at least one of silicon dioxide, BPSG and PSG. Further, layer 22 has a substantial thickness, preferably in the range of 6000Å to 15000Å prior to planarization, to enable both antifuse cell 14 and first conductive layer 14 to be sufficiently covered, and thereby insulated from any subsequent layers disposed over layer 22.

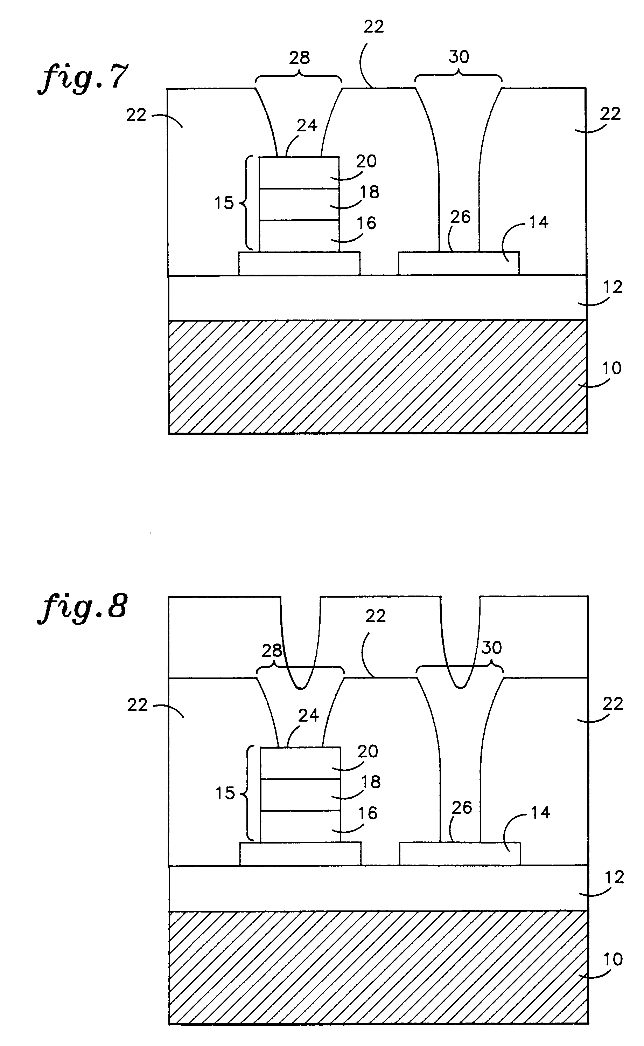

Referring to Figure 7, a semiconductor structure formed according to a fourth step of the present invention is shown. Here, third dielectric layer 22 is patterned to create a first and second via, 30 and 28, respectively. While layer 22 is patterned, it should be noted that the resultant structure of Figure 6 is otherwise unimpacted by this step.

The step of patterning, as described hereinabove, incorporates several process steps. In one embodiment, a layer of photoresist is patterned over those areas adjacent to vias 28 and 30. Further, photoresist is exposed and developed away where vias 28 and 30 are to be formed. Thus, by means of an etching step, vias 28 and 30 are created simultaneously in one embodiment of the present invention, while leaving intact the remainder of the third dielectric layer 22. Once etched, the photoresist is removed.

In the preferred embodiment, however, two separate photoresist deposition and etching steps are employed for each via, 28 and 30. The purpose of the preferred embodiment is in preventing premature damage to the antifuse. This is in view of the fact that the oxide may be thicker for vias not having an associated antifuse structure, thus requiring a longer etch.

The dimensions of both vias 28 and 30 are critical to the operation of the overall device. Via 28 comprises a critical dimension to enable access to the upper surface 24 of second barrier layer 20. This surface ultimately provides electrical contact between a subsequent conductive layer to be described hereinbelow and antifuse cell 15. Moreover, via 30 comprise a critical dimension to enable access to the upper surface 26 of the first conductive layer 14. Surface 26 ultimately provides electrical contact between a subsequent conductive layer and first conductive layer 14. Thus, positioning of the photoresist is critical in aligning upper surfaces 24 and 26 with a subsequent superjacent conductive layer. This is also supported by the fact that a subsequent conductive layer must be aligned with both vias.

Referring to Figure 8, a semiconductor structure formed according to a fifth step of the present invention is shown. Upon making vias 28 and 30, a second conductive layer 40 is formed superjacent the resultant structure of Figure 7. Second conductive layer 40 comprises a metallization layer having a thickness of substantially in the range of 6000Å to 10500Å. In the preferred embodiment - a triple level metal ("TLM") process - the preferred thickness is approximately 6000Å. This TLM comprises a first level having a thickness of approximately 6000Å, a second level having a a thickness of approximately 6000Å, and the third comprises 10500Å. Further, it should be obvious to one of ordinary skill in the art that a double level metal process can also be employed with respect to the present invention. Here, the first metal level comprises 6000Å and the second metal level comprises 10500Å. In one embodiment of the present invention, second conductive layer 40 preferably comprises an aluminum (98.5% concentration by weight), copper (0.5% concentration by weight) and silicon (1% concentration by weight) compound. The formation of second conductive layer 40 can be achieved through various methods known, including evaporation and sputtered deposition techniques.

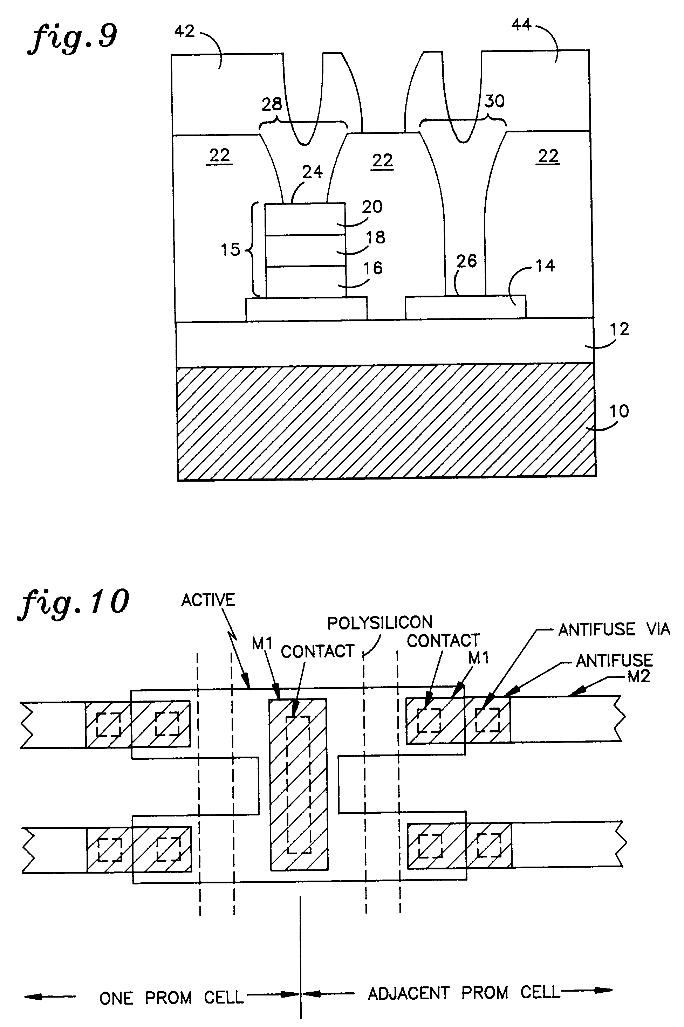

Referring to Figure 9, a semiconductor structure formed according to a sixth step of the present invention is shown. Here, second conductive layer 40 of Figure 8 is patterned to define conductive paths and create a first and second interconnect conductor, 44 and 42, for first and second via, 30 and 28, respectively. While layer 40 is patterned, it should be noted that the resultant structure of Figure' 8 is otherwise unimpacted by this step.

The step of patterning, as described hereinabove, incorporates several process steps. In one embodiment, a layer of photoresist is patterned over regions which will form the conductive paths for first and second via conductor 44 and 42. The region where interconnect conductors 44 and 42 overlap on second conductive layer 40 in Figure 8, however, is left bare in order to remove it. Thus, by means of an etching step, preferably employing plasma dry etching techniques which include Cl₂, BCl₃, or CH₄ chemistries, first and second interconnect conductors, 44 and 42, for first and second vias, 30 and 28, are formed along with conductive lines. Once etched, the remaining photoresist is removed.

By this arrangement, first contact 42 is electrically coupled with antifuse cell 15 through via 28 by means of upper surface 24. Similarly, second contact 44 is electrically coupled with first metal layer 14 through via 30 by means of upper surface 26.

The resultant resistance of the post-programmed and disintegrated antifuse cell is approximately 300Ω, depending on the programming current employed and the size of the transistor(s) which provides a path for the programming current. Thus, the post-programmed resistance can be less than 300Ω. In contrast, however, the pre-programmed resistance of the antifuse cell is approximately 1 x 10⁹ Ω.

Referring to Figure 10, a topographical view of two adjacent PROM cells employing the present invention is illustrated. From this perspective, it should be obvious to one of ordinary skill how both cells share a common contact.

Given this configuration, the herein disclosed semiconductor structure can be employed as an antifuse. Second contact 44, being electrically coupled with the upper surface 26 of the first conductive layer 14 through via 30, is grounded. Simultaneously, a positive voltage is applied on the upper surface 24 of the second barrier layer 20 of the antifuse cell 20 by means of first contact 42 of second conductive layer 40. This positive voltage is preferably in the range of approximately 7.5 to 12 volts. By applying this voltage essentially across the antifuse cell 15, the cell heats up, and a sufficiently high enough current passes through cell 15 to cause second dielectric layer 18 to disintegrate. The disintegration of second dielectric layer 18 results in a byproduct. Should a titanium based compound be employed to fabricate either first or second barrier layers, 16 or 18, this byproduct may comprise titanium silicide.

While the particular invention has been described with reference to illustrative embodiments, this description is not meant to be construed in a limiting sense. It is understood that although the present invention has been described in a preferred embodiment, various modifications of the illustrative embodiments, as well as additional embodiments of the invention, will be apparent to persons skilled in the art upon reference to this description without departing from the spirit of the invention, as recited in the claims appended hereto. Thus, upon understanding the present invention, one of ordinary skill in the art could employ the present invention in a variety of applications requiring antifuse technology. These applications include but are not limited to programmable devices such as programmable read only memories, programmable array logic units, and field programmable gate arrays, programmable controllers, as well as other programmable circuits. It is therefore contemplated that the appended claims will cover any such modifications or embodiments as fall within the true scope of the invention.

All of the U.S. Patents cited herein are hereby incorporated by reference as if set forth in their entirety.

## Claims

**1.** A method of fabricating a semiconductor wafer, comprising the steps of:
forming a patterned antifuse layer having a structural configuration superjacent a first conductive layer, said first conductive layer being superjacent a semiconductor substrate;
patterning said first conductive layer;
forming a patterned first dielectric layer superjacent said patterned antifuse layer and said patterned first conductive layer, said patterned first dielectric layer having a first and second via, such that a portion of said patterned antifuse layer is exposed through said first via, and a portion of patterned said first conductive layer is exposed through said second via, thereby forming a resultant structure; and
forming a second conductive layer superjacent said resultant structure, thereby providing electrical contacts between said second conductive layer and said patterned antifuse layer and between said second conductive layer and said first conductive layer.

**2.** The method of claim 1, further comprising the step of:
forming a second dielectric layer subjacent said patterned first conductive layer and superjacent said semiconductor substrate.

**3.** The method of claim 1 or 2 wherein said antifuse layer is patterned by the steps of:
forming a patterned layer of photoresist superjacent said antifuse layer, thereby leaving a portion of said antifuse exposed;
etching said portion of said antifuse layer; and
removing said photoresist from said antifuse layer.

**4.** A method of fabricating a semiconductor wafer, comprising the steps of:
forming a first dielectric layer superjacent a semiconductor substrate;
forming a first conductive layer superjacent said first dielectric layer;
forming a patterned antifuse layer having a structural configuration superjacent said first conductive layer;
patterning said first conductive layer while maintaining the structural configuration of said patterned antifuse layer, such that a portion of said first dielectric layer is exposed;
forming a patterned second dielectric layer superjacent said patterned antifuse layer, said first conductive layer, and said first dielectric layer, such that a portion of said patterned antifuse layer is exposed through a first via, and a portion of said first conductive layer is exposed through a second via, thereby forming a resultant structure; and
forming a second conductive layer superjacent said resultant structure, thereby providing electrical contacts between said second conductive layer and said patterned antifuse layer and between said second conductive layer and said first conductive layer.

**5.** The method of claim 4, wherein said forming a patterned second dielectric layer comprises the steps of:
forming said first via; and
forming said second via adjacent to said first via.

**6.** The method of claim 4 or 5, wherein said first dielectric layer comprises at least one of borophosphosilicate glass ("BPSG"), phosphosilicate glass ("PSG") and silicon dioxide.

**7.** The method of any one of claims 4 to 6, wherein said first conductive layer comprises at least one of aluminum, copper and silicon.

**8.** The method of any one of claims 4 to 7, wherein said patterned second dielectric layer comprises at least one of silicon dioxide, borophosphosilicate glass ("BPSG") and phosphosilicate glass ("PSG").

**9.** The method of any one of claims 4 to 8, wherein said second conductive layer comprises at least one of aluminum, copper, and silicon.

**10.** The method of any one of the preceding claims, wherein said patterned antifuse layer comprises:
a first barrier layer superjacent said conductive layer;
a third dielectric layer superjacent said first barrier layer; and
a second barrier layer superjacent said third dielectric layer.

**11,** The method of claim 10, wherein said first barrier layer comprises at least one of TiW and TiN.

**12.** The method of claim 10 or 11, wherein said third dielectric layer provides a substantially low capacitance between said first barrier layer and said second barrier layer.

**13.** The method of any one of claims 10 to 12, wherein said third dielectric layer comprises at least one of undoped amorphous silicon, polysilicon, doped silicon, and an oxide-nitride-oxide.

**14.** The method of any oneof claims 10 to 13, wherein said second barrier layer comprises at least one of TiW and TiN.

**15.** The method of any one of claims 4 to 14, wherein said antifuse layer is patterned by the steps of:
forming a patterned layer of photoresist superjacent a portion of said antifuse layer, thereby leaving a remaining portion of said antifuse layer exposed;
etching said remaining portion of said antifuse layer; and
removing said photoresist from said antifuse layer.

**16.** The method of any preceding claim, wherein said forming a first dielectric layer comprises the step of planarizing said first dielectric layer.

**17.** The method of claim 2 or 4 to 16, wherein said forming a patterned second dielectric layer comprises the step of planarizing said patterned second dielectric layer.

**18.** A method of fabricating a semiconductor memory having an antifuse, comprising the steps of:
forming a reflow glass layer superjacent a semiconductor substrate, said glass reflow layer comprising at least one of borophosphosilicate glass ("BPSG") and phosphosilicate glass ("PSG"), said reflow glass layer having a thickness substantially in the range of 7000Å to 9000Å;
forming a first conductive layer having a structural integrity superjacent said glass reflow layer, said first conductive layer comprises at least one of aluminum, copper and silicon, said first conductive layer having a thickness substantially in the range of 5000Å to 7000Å;
forming an antifuse layer having a structural integrity superjacent said first conductive layer, said antifuse layer comprising:
a first barrier layer superjacent said first conductive layer, said first barrier layer comprising at least one of TiW and titanium nitride, said first barrier layer having a thickness substantially in the range of 1200Å to 2000Å;
a first dielectric layer superjacent said first barrier layer, said first dielectric layer having a thickness substantially within the range of 800Å to 1600Å, said first dielectric layer comprising at least one of undoped amorphous silicon, polysilicon, doped silicon and an oxidenitride-oxide; and
a second barrier layer superjacent said second dielectric layer, said second barrier layer comprises at least one of TiW and TiN, said second barrier layer having a thickness substantially in the range of 1200Å to 2000Å;
patterning said antifuse layer;
patterning said first conductive layer such that a portion of said reflow glass layer is exposed;
forming a patterned second dielectric layer superjacent said antifuse cell, said first conductive layer, and said reflow glass layer, said patterned second dielectric layer comprising at least one of silicon dioxide, borophosphosilicate glass ("BPSG") and phosphosilicate glass ("PSG"), said patterned second dielectric layer having a first and second via, such that a portion of said antifuse cell is exposed through said first via, and a portion of said first conductive layer is exposed through said second via, thereby forming a resultant structure; and
forming a second conductive layer superjacent said resultant structure, said second conductive layer having a thickness of substantially in the range of 6000Å to 10500Å, said second conductive layer comprising at least one of aluminum, copper, and silicon, thereby providing electrical contacts between said second conductive layer and said antifuse cell and between said second conductive layer and said first conductive layer.

**19.** A semiconductor memory having an antifuse, said memory comprising:
a reflow glass layer superjacent a semiconductor substrate, said reflow glass layer comprising at least one of borophosphosilicate glass ("BPSG"), phosphosilicate glass ("PSG"), and silicon dioxide:
a first conductive layer superjacent said reflow glass layer, said first conductive layer being patterned, such that a portion of said reflow glass layer is exposed comprises at least one of aluminum, copper and silicon;
a antifuse cell superjacent said first conductive layer, said antifuse cell comprising:
a planar first barrier layer superjacent said patterned first conductive layer, said first barrier layer comprising at least one of TiW and TiN;
a planar first dielectric layer superjacent said first barrier layer, said first dielectric layer comprising at least one of undoped amorphous silicon, polysilicon, doped silicon, and an oxide-nitride-oxide; and
a planar second barrier layer superjacent said second dielectric layer, said second barrier layer comprising at least one of TiW and TiN;
a second dielectric layer superjacent said antifuse cell, said first conductive layer, and said reflow glass layer, said second dielectric layer being patterned such that a first and second via are formed and that a portion of said antifuse cell is exposed through said first via, and a portion of said first conductive layer is exposed through said second via, thereby forming a resultant structure, said second dielectric layer comprising at least one of silicon dioxide, borophosphosilicate glass ("BPSG") and phosphosilicate glass ("PSG"); and
a second conductive layer superjacent said resultant structure, said second conductive layer comprising at least one of aluminum, copper, and silicon, thereby providing electrical contacts between said second conductive layer and said antifuse cell and between said second conductive layer and said first conductive layer, said electrical contact between said first and said second conductive layer having a substantially low resistivity.
